# EUROPÄISCHE PATENTSCHRIFT

(11) **EP 2 179 451 B1**
(45) Veröffentlichungstag und Bekanntmachung des Hinweises auf die Patenterteilung: **23.02.2011**
(21) Anmeldenummer: 08801878.3
(22) Anmeldetag: 05.09.2008
(51) Int. Cl.: H01L 31/042, H02J 7/35, G05F 1/67

(54) **Steuerbare Umschaltvorrichtung für ein Solarmodul**
Controllable switch-over device for a solar module
Dispositif de commutation régulable pour module solaire

(30) Priorität: 12.10.2007 DE 102007048974; 16.01.2008 DE 102008004675
(43) Veröffentlichungstag der Anmeldung: 28.04.2010
(73) Patentinhaber: Fraunhofer-Gesellschaft zur Förderung der angewandten Forschung e.V., 80686 München (DE)
(72) Erfinder: BURGER, Bruno, 79110 Freiburg (DE); SCHMIDT, Heribert, 79117 Freiburg (DE)
(74) Vertreter: Zimmermann, Tankred Klaus
(86) Internationale Anmeldenummer: PCT/EP2008/007285
(87) Internationale Veröffentlichungsnummer: WO 2009/049717

(56) Entgegenhaltungen:
- WO-A-03/098703
- WO-A-2006/079503
- JP-A- 2005 235 082

## Beschreibung

### Beschreibung

Die vorliegende Erfindung bezieht sich auf eine steuerbare Umschaltvorrichtung für ein Solarmodul und ein Verfahren zum Steuern derselben.

Ein Solarmodul wandelt elektro-magnetische Strahlung, wie z.B. das Licht der Sonne, in elektrische Energie um und weist beispielsweise mehrere Solarzellen-auf.

Solarmodule werden einzeln oder zu Gruppen verschaltet, beispielsweise in Photovoltaikanlagen, kleinen stromnetzunabhängigen Verbrauchern oder zur Stromversorgung von Raumfahrzeugen verwendet.

Die elektrischen Anschlusswerte eines Solarmoduls, die das Solarmodul charakterisieren, sind z. B. Leerlaufspannung und Kurzschlussstrom. Diese können von den Eigenschaften der einzelnen Solarzellen und der Verschaltung der Solarzellen innerhalb des Moduls abhängen.

Werden mehrere Module in Reihe betrieben, so können antiparallel zu jedem Modul bzw. Teilstring eine Freilaufdiode bzw. Bypassdiode geschaltet sein. Die Freilaufdiode kann so an den Anschlussklemmen jedes Moduls angeschlossen sein, dass sie im normalen Betriebszustand, zu dem das Modul Strom liefert, in Sperrrichtung gepolt ist.

Solarmodule sind in der Regel mit einer Anschlussdose ausgestattet, in der die zu entsprechenden Teilstrings im Modul antiparallel geschalteten Bypassdioden und die Anschlussklemmen für das Solarmodul untergebracht sind.

Wird ein Teilstring des Moduls abgeschattet, so leitet dessen Bypassdiode den Differenzstrom zwischen dem Strom des abgeschatteten Modulstrings und des Solargeneratorstrangs. Dadurch, dass die Bypassdiode leitet, wird die Spannung des abgeschatteten Modulstrings fast zu Null (ca. -1 Volt), so dass der abgeschattete Modulstring keine Leistung mehr produziert.

Um dies zu verhindern, können DC/DC-Wandler eingesetzt werden, die den Strom und die Spannung so anpassen, dass der abgeschattete Modulstring trotzdem noch Leistung abgibt. Nachteil dabei ist jedoch, dass der DC/DC-Wandler auch im nichtabgeschatteten Fall arbeitet und dabei elektrische Verluste produziert und den Gesamtwirkungsgrad des Solargenerators vermindert. Ein solches Modulstring ist in dem Dokument WO-A-03098703 offenbart.

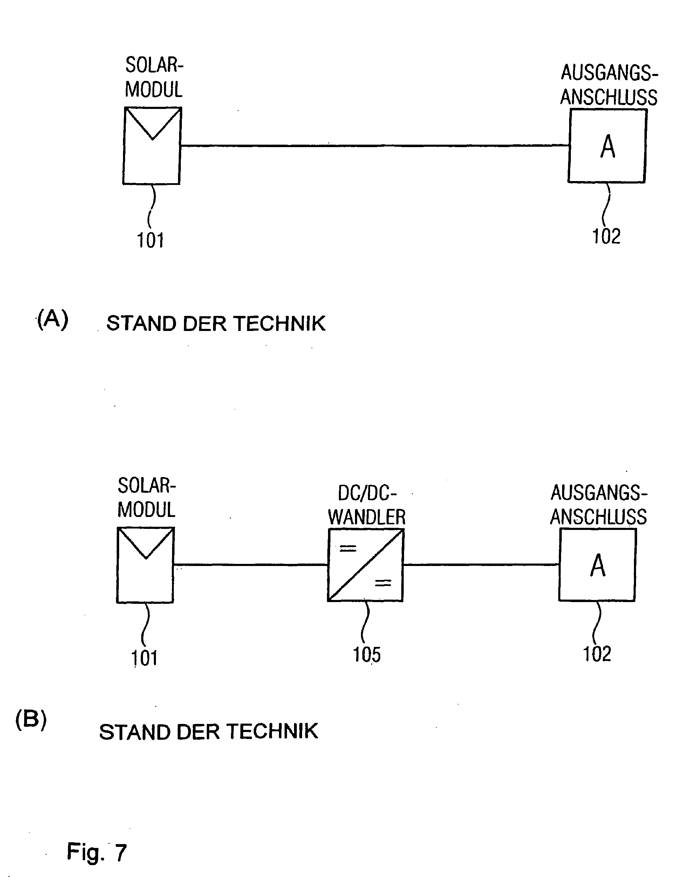

Fig. 7A zeigt den Fall eines Solarmoduls 101, das direkt mit dem Modulanschluss 102 gekoppelt ist, während Fig. 7B den Fall eines Solarmoduls 101 zeigt, das über einen DC/DC-Wandler 105 an den Modulanschluss 102 angeschlossen ist. In dem Fall von Fig. 7Aa treten zwar keine Leistungsverluste aufgrund eines DC/DC-Wandlers 105 auf, aber Abschattungen des Solarmoduls 101 führen zu den oben beschriebenen Prolemen. Umgekehrt führt zwar in dem Fall von Fig. 7B eine Abschattung des Solarmoduls 101 nicht zu einer Unterbrechung der Leistungsabgabe, aber es tritt auch bei voller Ausleuchtung des Solarmoduls 101 eine Beeinträchtigung des Gesamtwirkungsgrads des Solargenerators auf.

Die Aufgabe der vorliegenden Erfindung besteht darin, den Wirkungsgrad eines Solarmoduls zu erhöhen.

Diese Aufgabe wird durch eine steuerbare Umschaltvorrichtung für ein Solarmodul gemäß Patentanspruch 1 oder durch ein Verfahren zum Steuern einer steuerbaren Umschaltvorrichtung für ein Solarmodul nach Patentanspruch 11 gelöst.

Ein Kerngedanke der vorliegenden Erfindung basiert darauf, dass eine Leistungserhöhung erzielbar ist, wenn eine Umschaltbarkeit vorgesehen wird, wonach das Solarmodul direkt an einen Ausgangs- bzw. Modulanschluss oder über einen DC/DC-Wandler an den Modulanschluss angeschlossen wird. Welche der beiden Anschlussarten zur optimalen Energienutzung verwendet werden soll, kann von einer Ansteuerung bestimmt werden, die unter Verwendung einer am Leistungsausgang des Solarmoduls oder einer am Modulanschluss vorliegenden Leistungskenngröße eine steuerbare Schalteinrichtung in die erste Stellung, bei der das Solarmodul über den DC/DC-Wandler auf den Modulanschluss geschaltet ist, oder in die zweite Stellung, bei der das Solarmodul direkt auf den Modulanschluss geschaltet ist, versetzt. Anders ausgedrückt kann die Leistungskenngröße am Leistungsausgang des Solarmoduls, die Informationen über die momentan erzeugte Leistung des Solarmoduls enthält, genutzt werden, um eine effiziente Ansteuerung der steuerbaren Schalteinrichtung zu bewirken, in der Hinsicht, den Wirkungsgrad des Solarmoduls zu erhöhen.

Bevorzugte Ausführungsbeispiele der vorliegenden Erfindung werden nachfolgend Bezug nehmend auf die beiliegenden Zeichnungen detailliert erläutert. Es zeigen:
- Fig. 1: ein Blockschaltbild einer steuerbaren Um- schaltvorrichtung für ein Solarmodul gemäß einem Ausführungsbeispiel, wobei Fig. 1A ein modifiziertes Ausführungsbeispiel zeigt.;
- Fig. 2A und 2B: das Spannung/Strom-Kennlinienfeld eines Solarmoduls für unterschiedlich starke Ein- strahlungen (a) bis (d) bzw. das Span- nung/Leistung-Kennlinienfeld des Solarmoduls für unterschiedlich starke Einstrahlungen (a) bis (d);
- Fig. 3: ein Blockschaltbild einer steuerbaren Um- schaltvorrichtung für ein Solarmodul gemäß einem weiteren Ausführungsbeispiel;
- Fig. 4: ein Blockschaltbild einer steuerbaren Um- schaltvorrichtung für ein Solarmodul gemäß wiederum einem weiteren Ausführungsbeispiel;
- Fig. 5: ein Blockschaltbild für eine Ansteuerung für eine steuerbare Umschaltvorrichtung gemäß einem Ausführungsbeispiel;
- Fig. 6: ein Flussdiagramm zur Veranschaulichung der Funktionsweise der Ansteuerung von Fig. 5; und
- Fig. 7A und 7B: Blockschaltbilder für herkömmliche An- schlusskonfigurationen für Solarmodule.

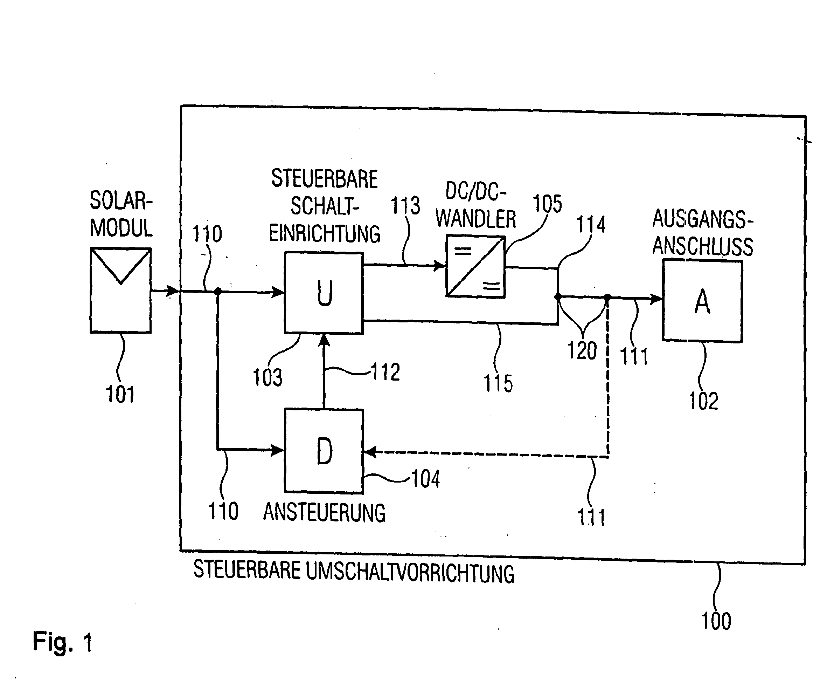

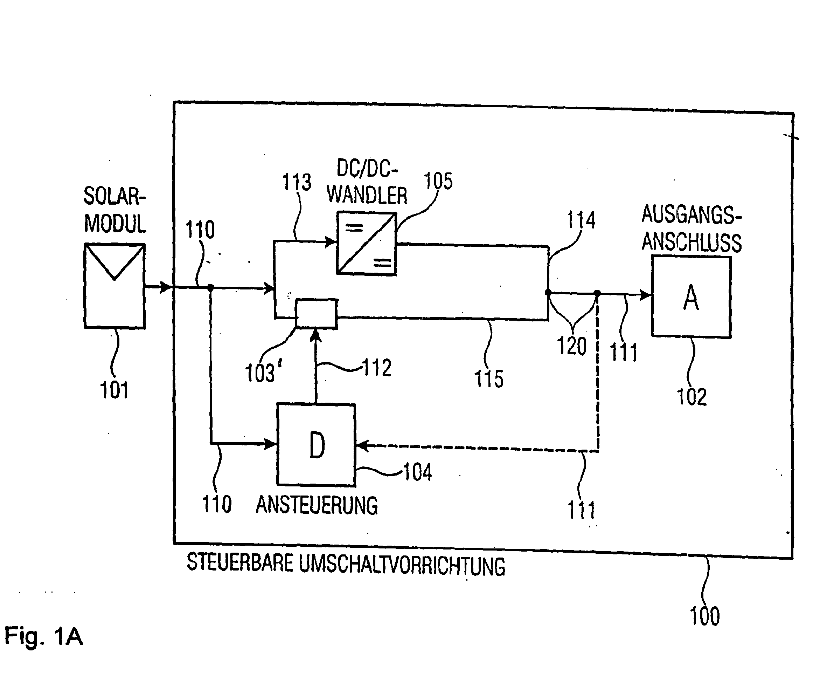

Fig. 1 zeigt ein Blockschaltbild einer steuerbaren Umschaltvorrichtung 100 für ein Solarmodul 101. Sie umfasst einen Ausgangsanschluss 102, eine steuerbare Schalteinrichtung 103, eine Ansteuerung 104, sowie einen DC/DC-Wandler 105.

Das Solarmodul 101 hat einen Ausgang 110 der mit einem Eingang der steuerbaren Schalteinrichtung 103 und der Ansteuerung 104 verbunden ist. Die steuerbare Schalteinrichtung 103 weist zwei Ausgänge 113 und 115 auf, von denen der Ausgang 113 über den DC/DC-Wandler 105 mit einem Ausgangsanschluss 102 verbunden ist und der Ausgang 115 direkt mit dem Ausgangsanschluss 102 verbunden ist. Die Ansteuerung 104 hat einen Eingang 110, der mit dem Ausgang des Solarmoduls verbunden ist, und/oder einen zweiten Eingang 111, der mit dem Ausgangsanschluss 102 verbunden ist. Anders ausgedrückt existiert in Fig. 1 ein Knotenpunkt 120, an den ein Ausgang des DC/DC-Wandlers 105 und der zweite Ausgang 115 der steuerbaren Schalteinrichtung 103 sowie der Ausgangsanschluss 102 und der zweite Eingang der Ansteuerung 104 angeschlossen sind.

Die steuerbare Umschaltvorrichtung 100 kann den Wirkungsgrad des Solarmoduls 101 erhöhen, indem sie berücksichtigt, dass zu Zeitpunkten hoher Ausleuchtung des Solarmoduls 101 und Zeitpunkten geringer Ausleuchtung die direkte Kopplung des Solarmoduls über die steuerbare Schalteinrichtung 103 mit dem Ausgangsanschluss 102 oder die indirekte Kopplung über den DC/DC-Wandler 105 zu bevorzugen ist.

Im Folgenden werden die vier Fälle erörtert, die unterschiedliche Kombinationen von direkter und indirekter Kopplung einerseits und hoher und geringer Ausleuchtung andererseits betreffen, sowie Vor- und Nachteile der vier Fälle aufgezeigt. Es können die folgenden vier Varianten unterschieden werden: "V1. Starke Sonneneinstrahlung ohne DC/DC-Wandler", "V2. Starke Sonneneinstrahlung mit DC/DC-Wandler", "V3. Schwache Sonneneinstrahlung mit DC/DC-Wandler" und "V4. Schwache Sonneneinstrahlung ohne DC/DC-Wandler".

Bei einer starken Sonneneinstrahlung ist die Leistungskenngröße am Leistungsausgang 110 des Solarmoduls 101 groß und das Solarmodul 101 sollte direkt mit dem Modulausgang 102 verbunden sein, d.h., Variante V1 ist zu nutzen. Ist in diesem Fall das Solarmodul 101 mittels DC/DC-Wandler 105 mit dem Modulausgang 102 verbunden, d.h., wird Variante V2 eingesetzt, so kann es im DC/DC-Wandler 105 aufgrund beispielsweise seiner nichtidealen Bauweise zu einem Leistungsabfall kommen, welcher den Gesamtwirkungsgrad reduziert.

Bei schwacher Sonneneinstrahlung bzw. Abschattung ist die Leistungskenngröße am Leistungsausgang 110 des Solarmoduls 101 klein und das Solarmodul 101 sollte gemäß Variante V3 über einen DC/DC-Wandler 105 mit dem Modulausgang 102 verbunden sein. Ist in diesem Fall das Solarmodul 101 direkt mit dem Modulausgang 102 verbunden, d.h., wird Variante V4 genutzt, so reduziert sich die erzeugte Leistung, im Extremfall kann es auftreten, dass das Solarmodul 101 keinen Strom mehr liefert und sich die Spannung an den Klemmen umpolt, so dass die Freilaufdiode (nicht gezeigt) innerhalb des Solarmoduls 101 leitet und das Solarmodul 101 keine Leistung mehr produziert. In jedem Fall reduziert sich der Wirkungsgrad des Solarmoduls 101, wenn es ohne DC/DC-Wandler 105 betrieben wird.

Wie im Folgenden näher erklärt wird, werden die zwei Negativvarianten "V2. Starke Sonneneinstrahlung mit DC/DC-Wandler" und "V4. Schwache Sonneneinstrahlung ohne DC/DC-Wandler" durch die steuerbare Umschaltvorrichtung 100 vermieden, indem die Ansteuerung 104 in dem Fall einer höheren Leistungskenngröße an 110 und/oder 111 die direkte Kopplung über 115 wählt und umgekehrt. Bevor jedoch die Funktionsweise der steuerbaren Umschaltvorrichtung 100 näher erörtert wird, soll im Folgenden kurz auf die einzelnen Komponenten eingegangen werden.

Das Solarmodul 101 kann mehrere Halbleitersolarzellen (nicht gezeigt) aufweisen, die zur Energiegewinnung zusammen verschaltet sind. Die Zellen können mit Leiterbahnen an beispielsweise Vorder- und Rückseite in Reihe geschaltet sein, wodurch sich die Spannung der Einzelzellen addieren und dünnere Drähte für die Verschaltung verwendet werden können als bei einer Parallelschaltung. Als Schutz vor einem Lawinendurchbruch in den einzelnen oben genannten Fällen, wie z. B. bei Teilabschattung, können die zuvor erwähnten nicht gezeigten Schutzdioden bzw. Bypassdioden parallel zu den Zellen eingebaut sein, die die von Abschattung betroffenen Zellen überbrücken können.

Das Solarmodul 101 kann durch bestimmte Kennwerte definiert sein, wie z.B. Leerlaufspannung, Kurzschlussstrom, Spannung im Betriebspunkt mit maximaler Leistung, Strom im Betriebspunkt mit maximaler Leistung, Leistung im Betriebspunkt mit maximaler Leistung, Füllfaktor, Koeffizient für die Leistungsänderung mit der Zelltemperatur und Modulwirkungsgrad. Um einen hohen Wirkungsgrad zu erzielen, sollte das Solarmodul 101 möglichst im Arbeitspunkt mit maximaler Leistung betrieben werden, welcher durch den Strom im Betriebspunkt mit maximaler Leistung und die Spannung im Betriebspunkt mit maximaler Leistung beschrieben wird. Die Leistung an dem Ausgang 110 des Solarmoduls 101 schwankt, wie bereits erwähnt, mit dem Grad der Ausleuchtung des Solarmoduls 101. Als Maß für die Leistung bzw. den Auslastungsgrad des Solarmoduls 101 verwendet die Ansteuerung 104 eine Leistungskenngröße des Ausgangssignals 110 des Solarmoduls 101, die Strom und/oder Spannung am Ausgang 110 aufweisen kann, um die steuerbare Schalteinrichtung 103 zu steuern. Alternativ oder zusätzlich verwendet die Ansteuerung 104 eine Leistungskenngröße des Signals 111 am Ausgangsanschluss 102, die von Strom und/oder Spannung abhängen kann, zur Steuerung der steuerbaren Schalteinrichtung 103.

Die Ansteuerung 104 kann ferner ausgebildet sein, um abhängig von der Leistungskenngröße am Leistungsausgang 110 des Solarmoduls 101 den Arbeitspunkt des Solarmoduls einzustellen, wobei aus Übersichtlichkeitsgründen in Fig. 1 ein entsprechender Pfeil nicht gezeigt ist. Der Arbeitspunkt könnte alternativ natürlich von einer Steuerung (nicht gezeigt) jenseits der steuerbaren Umschaltvorrichtung 100, wie z.B. innerhalb des Solarmoduls 101 selbst, geregelt oder gesteuert werden. In diesem Fall könnte die Ansteuerung 104 die Arbeitspunkteinstellung der Arbeitspunktsteuerung als Leistungskenngröße verwenden.

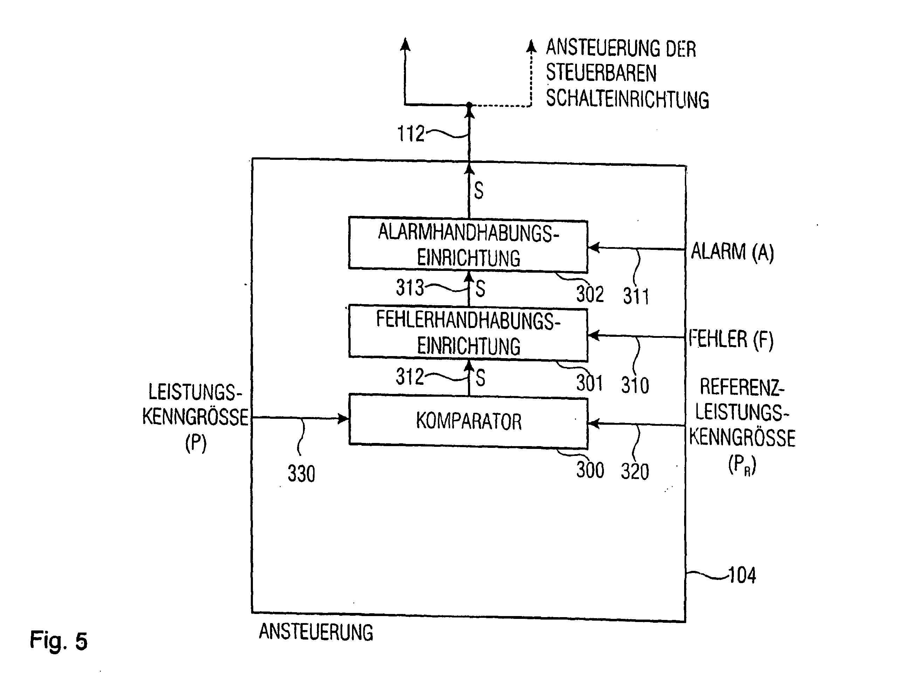

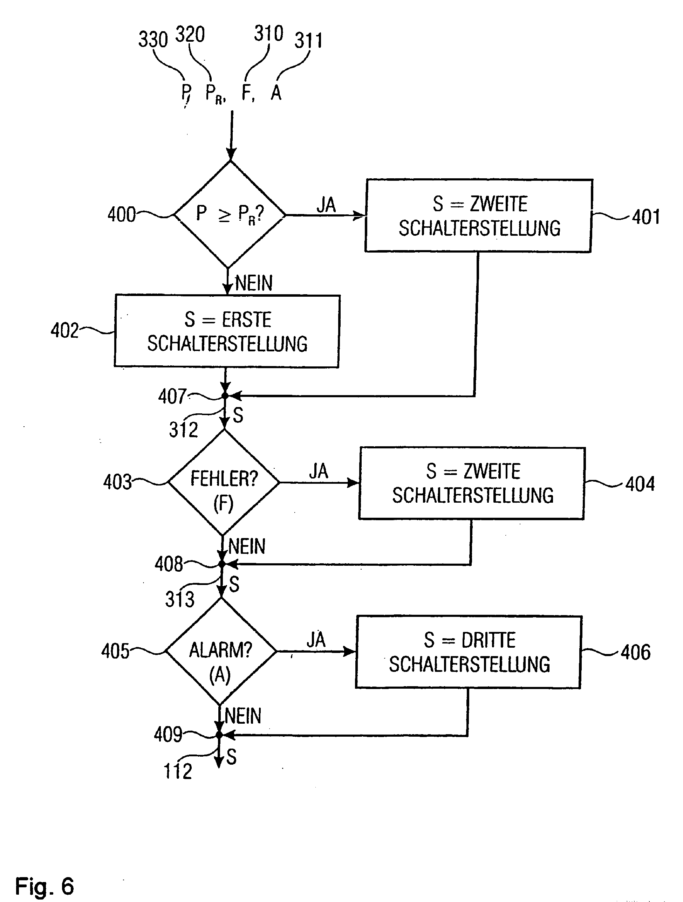

Die steuerbare Schalteinrichtung 103 ist eine Schalteinrichtung mit zwei Schalterstellungen, wobei in einer ersten Schalterstellung ein Leistungsausgang 110 des Solarmoduls 101 über den DC/DC-Wandler 105 auf den Ausgangsanschluss 102 geschaltet ist, und wobei in einer zweiten Schalterstellung der Leistungsausgang 110 des Solarmoduls 101 unter Umgehung des DC/DC-Wandlers 105 auf den Ausgangsanschluss 102 geschaltet ist. Der Schalter der steuerbaren Schalteinrichtung 103 wird geschaltet über die Ansteuerung 104, welche ein Ansteuersignal 112 liefert, mit dem der Schalter in die erste oder zweite Stellung geschaltet wird. Die Ansteuerung 104 steuert die steuerbare Schalteinrichtung 103 unter Verwendung der am Leistungsausgang des Solarmoduls 101 vorliegenden Leistungskenngröße 110 und/oder einer am Ausgangsanschluss 102 vorliegenden Leistungskenngröße 111, wobei die steuerbare Schalteinrichtung 103 in die erste oder in die zweite Schalterstellung geschaltet wird. Eine nähere Beschreibung einer möglichen Ausführung der Ansteuerung 104 folgt in Fig. 5 und in Fig. 6.

Die steuerbare Schalteinrichtung 103 kann einen Schalter, der in analoger Schaltungstechnik oder in digitaler Schaltungstechnik realisiert ist, umfassen, und zwar in analoger Schaltungstechnik beispielsweise einen Operationsverstärkers, der in Abhängigkeit einer anliegenden Spannung den einen oder den anderen Eingang auf den Ausgang durchschaltet, oder in digitaler Schaltungstechnik eine Transistorschaltung, deren Transistoren als diskrete Schaltelemente ausgestaltet sind.

Die Ansteuerung 104 kann ebenfalls in analoger oder digitaler Schaltungstechnik ausgebildet sein. Beispielsweise ist eine Ansteuerung 104 mittels eines Komparators zu realisieren, der in analoger Schaltungstechnik als ein Operationsverstärker ausgebildet sein kann. In dieser Ausbildung hat der Komparator einen positiven und einen negativen Spannungseingang, zwei Spannungsversorgungseingänge und einen Spannungsausgang. Ist die Spannung am positiven Eingang höher als die Spannung am negativen Eingang, so nähert sich die Ausgangsspannung der positiven Versorgungsspannung. Bei umgekehrten Verhältnissen geht die Ausgangsspannung gegen die negative Versorgungsspannung. Realisiert wird der Komparator häufig als spezieller Operationsverstärker, der ohne Gegenkopplung, d. h. mit sehr hoher Verstärkung betrieben wird. Es existieren speziell für den Anwendungszweck als Komparator entwickelte integrierte Schaltungen, mit mehreren Komparatoren auf einem Chip, deren Verstärkerstufen nicht auf linearen Betrieb, sondern auf schnelles Umschalten und Kompatibilität zu Logikschaltkreisen hin optimiert sind. Neben Komparatoren kann die Ansteuerung 104 weitere Operationsverstärker enthalten, die als addierbare Summierverstärker, Differenzverstärker, Subtrahierverstärker, oder invertierende Verstärker ausgebildet sind. Mittels dieser Elemente kann die ganze Logik der Ansteuerung 104 in analoger Schaltungstechnik realisiert werden. Ferner kann die Ansteuerung auch in digitaler Schaltungstechnik ausgebildet sein, d. h. als ein Mikroprozessor, der einen Programmcode abarbeitet oder als ein FPGA (Field programmable gate array), welches digitale Logikelemente verschaltet oder als eine integrierte Schaltung mittels Halbleiterelemente, die in Hardware realisiert ist.

Der DC/DC-Wandler 105 ist eine elektronische Schaltung zur Spannungswandlung. Zur Speicherung der Energie kann dabei eine Induktivität benutzt werden (induktiver Wandler).

Die Ansteuerung 104 steuert die steuerbare Schalteinrichtung 103 abhängig von der vom Solarmodul 101 gelieferten Leistung 110, so dass das Solarmodul 101 entweder direkt mit dem Ausgangsanschluss 102 oder über den DC/DC-Wandler 105 mit dem Ausgangsanschluss 102 verbunden ist. Bei ausreichend hoher Ausleuchtung des Solarmoduls 101, d.h., bei starker Bestrahlung, erzeugt das Solarmodul 101 eine hohe Leistung, was die Ansteuerung 104 an der hohen Leistungskenngröße erkennt, so dass sie bewirkt, dass die Leistung über die steuerbare Schalteinrichtung 103 verlustfrei auf den Ausgangsanschluss 102 geschaltet wird.

Die Ansteuerung 104 benötigt zur Auswertung der von dem Solarmodul 101 gelieferten Leistung 110 einen Schwellwert, anhand dessen sie entscheiden kann, ob sich das Solarmodul 101 im Zustand der starken Bestrahlung oder im Zustand der Abschattung befindet, und abhängig davon die gelieferte Leistung direkt auf den Ausgangsanschluss 102 führen kann oder den DC/DC-Wandler 105 zwischenschalten kann.

Ein Ausführungsbeispiel für die Ansteuerung 104 zeigt das Blockschaltbild in Fig. 5. Der oben angeführte Schwellwert ist dabei als eine Referenzleistungskenngröße 320 ausgebildet, die von außen an die Ansteuerung 104 geführt wird.

Bei Teilabschattung des Solarmoduls 101, d.h., bei geringer Bestrahlung, erzeugt das Solarmodul 101 nur eine geringe Leistung. In diesem Fall erkennt die Ansteuerung 104 die Reduktion in der von dem Solarmodul 101 gelieferten Leistung 110 und schaltet den DC/DC-Wandler 105 zwischen Solarmodul 101 und Ausgangsanschluss 102.

Durch die steuerbare Umschalteinrichtung 100 wird der Wirkungsgrad des Solarmoduls 101 erhöht, da der DC/DC-Wandler 105 nur dann zugeschaltet wird, wenn er auch benötigt wird, und es somit zu keinem unnötigen Leistungsabfall an seinen Bauelementen kommt.

Fig. 1A zeigt ein Blockschaltbild einer steuerbaren Umschaltvorrichtung 100 für ein Solarmodul 101 gemäß einem modifizierten Ausführungsbeispiel. Elemente, die bereits anhand der Fig. 1 beschreiben wurden, werden nicht nochmals beschreiben. Bei diesem Ausführungsbeispiel ist die steuerbare Schalteinrichtung gegenüber der in Fig. 1 gezeigten modifiziert. Anders als in Fig. 1 ist bei der Ausgestaltung gemäß Fig. 1A der DC/DC-Wandler 105 parallel mit einer Schalteinrichtung 103' als Bypass- bzw. Überbrückungsschaltung (z.B. mechanischer Schalter oder Halbleiterschalter) in der Leitung 115 verschaltet. Die Schalteinrichtung 103' wird durch die Ansteuerung 104 angesteuert, wie dies oben anhand der Fig. 1 beschrieben wurde, um in einer ersten Schalterstellung (offen) den Leistungsausgang 110 des Solarmoduls 101 über den DC/DC-Wandler 105 auf den Ausgangsanschluss 102 zu schalten, und um in der zweiten Schalterstellung (geschlossen) den DC/DC-Wandler 105 zu überbrücken, um den Leistungsausgang 110 des Solarmoduls 101 direkt auf den Ausgangsanschluss 102 zu schalten.

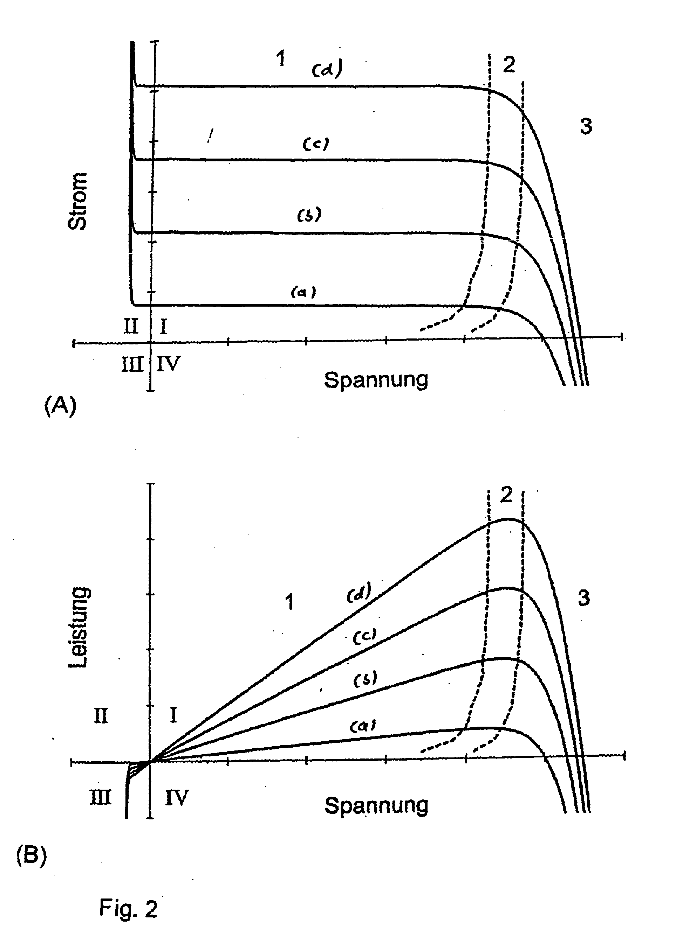

Die Fig. 2A und 2B zeigen Kennlinienfelder für ein Solarmodul für verschiedene Einstrahlungen, wobei Fig. 2A das Spannung/Strom-Kennlinienfeld für zunehmende Einstrahlungen (a) bis (d) zeigt. Im Quadranten I sind die Bereiche 1, 2 und 3 dargestellt, wobei im Bereich 1 der Stromverlauf im Wesentlichen horizontal ist, über den Bereich 2 leicht abfällt und im Bereich 3 stark abfällt und in den Quadranten IV übergeht. Im Quadranten II steigt der Strom stark an, da in diesem Bereich die Bypass-Dioden leiten.

In Fig. 2B ist das Spannung/Leistung-Kennlinienfeld ebenfalls für unterschiedlich starke Einstrahlungen (a) bis (d) gezeigt, wobei hier ebenfalls im Quadranten I die Bereiche 1, 2 und 3 gezeigt sind. Wie zu erkennen ist, steigt die Leistung im Bereich 1 im Wesentlichen linear an, erreicht im Bereich 2 ein Maximum und fällt im-Bereich 3 ab.

Gemäß der vorliegenden Erfindung ist die Ansteuerung 104 ausgestaltet, um das Zuschalten des DC/DC-Wandlers in den Bereichen 1 und 3 zu bewirken, wohingegen im Bereich 2 eine direkte Verbindung des Solarmoduls mit dem Ausgangsanschluss erfolgt. Der Bereich 2 in den Diagrammen in Fig. 2A und 2B ist der Bereich um den Ort maximaler Leistung, der sich bei der optimalen Betriebspunkteinstellung des Solarmoduls ergibt, wobei gemäß dem Ausführungsbeispiel der Bereich 2 einer Leistung von etwa 2 % unter der maximalen Leistung über dem Punkt der maximalen Leistung zu einem Punkt wiederum etwa 2 % unterhalb der maximalen Leistung erstreckt.

Sofern die von der Ansteuerung erfasste, von dem Solarmodul ausgegebene Leistung innerhalb dieses Bereichs liegt, erfolgt eine direkte Verbindung des Ausgangs des Solarmoduls mit dem Ausgangsanschluss, andernfalls, nämlich in den Bereichen 1 und 3 wird, wie erwähnt, der DC/DC-Wandler zwischengeschaltet.

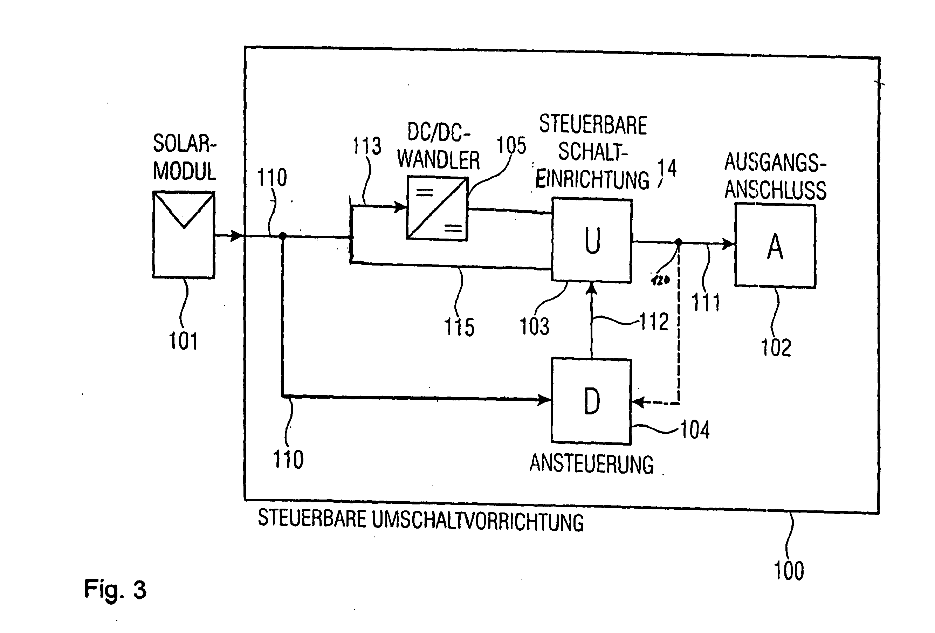

Die Fig. 3 zeigt ein weiteres Ausführungsbeispiel der erfindungsgemäßen, steuerbaren Umschaltvorrichtung, die im Wesentlichen dem Aufbau der Fig. 1 entspricht, wobei, anders als in Fig. 1, hier die Schalteinrichtung 103 zwischen den DC/DC-Wandler 105 und den Knoten 120 geschaltet ist. Der Ausgang des Solarmoduls 101 ist also parallel mit einem Eingang der Schalteinrichtung 103 und über den DC/DC-Wandler und einen weiteren Eingang der Schalteinrichtung 103 verbunden, so dass über diese abhängig von dem anliegenden Ansteuersignal auf die oben beschriebene Art und Weise der Ausgang des Solarmoduls entweder direkt mit dem Ausgangsanschluss 102 oder über den DC/DC-Wandler mit dem Ausgangsanschluss 102 verbunden werden kann.

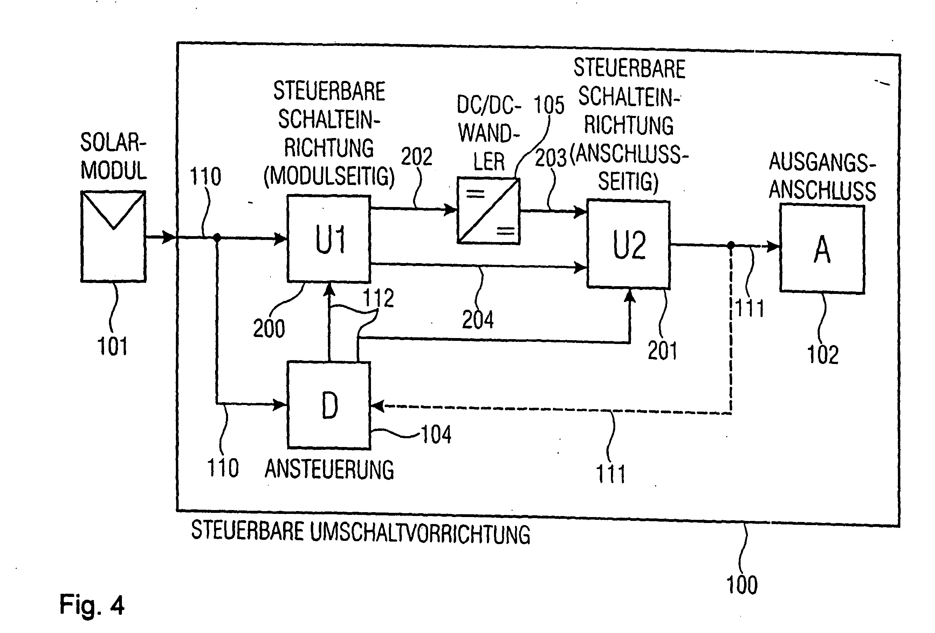

Fig. 4 zeigt ein Blockschaltbild einer steuerbaren Umschaltvorrichtung 100 mit einem modulseitigen 200 und einem anschlussseitigen Teil 201. In Fig. 1 ist die anschlussseitige Ankopplung mittels Verzweigungspunkt 120 realisiert, wobei davon ausgegangen wird, dass das Ausgangssignal 110 des Solarmoduls 101 entweder über den DC/DC-Wandler 105 geführt wird oder direkt zum Ausgangsanschluss 102 geführt wird. In Fig. 4 ist der Verzweigungspunkt 120 aus Fig. 1 Teil der steuerbaren Schalteinrichtung 103, die aus einem modulseitigen Teil, im folgenden als modulseitige steuerbare Schalteinrichtung 200 bezeichnet, und einem anschlussseitigen Teil, im folgenden als anschlussseitige steuerbare Schalteinrichtung 201 bezeichnet, ausgebildet ist. Fig. 1 und Fig. 4 zeigen somit zwei Ausbildungen der steuerbaren Umschaltvorrichtung auf. Der Ausgang 110 des Solarmoduls 101 ist mit dem Eingang 110 der steuerbaren Umschaltvorrichtung 100 verbunden. Die steuerbare Umschaltvorrichtung 100 besteht aus einem Ausgangsanschluss 102, einer modulseitigen steuerbaren Schalteinrichtung 200, einer anschlussseitigen steuerbaren Schalteinrichtung 201, einer Ansteuerung 104 sowie einem DC/DC-Wandler 105.

Das Solarmodul 101 hat einen Ausgang, der mit einem Eingang der modulseitigen steuerbaren Schalteinrichtung 200 verbunden ist. Die modulseitige steuerbare Schalteinrichtung 200 hat zwei Eingänge und zwei Ausgänge. Ein Eingang 110 ist mit dem Ausgang des Solarmoduls 101 verbunden. Der zweite Eingang 112 ist mit dem Ausgang der Ansteuerung 104 verbunden. Ein Ausgang 202 der steuerbaren modulseitigen Schalteinrichtung 200 ist mit dem Eingang des DC/DC-Wandlers 105 verbunden, der andere Ausgang 204 ist mit dem zweiten Eingang der anschlussseitigen steuerbaren Schalteinrichtung 201 verbunden. Die anschlussseitige steuerbare Schalteinrichtung 201 hat drei Eingänge und einen Ausgang. Ein Eingang 203 ist mit dem Ausgang des DC/DC-Wandlers 105 verbunden. Der zweite Eingang 204 ist mit dem zweiten Ausgang der modulseitigen steuerbaren Schalteinrichtung 200 verbunden. Ein dritter Eingang 112 der anschlussseitigen steuerbaren Schalteinrichtung 201 ist mit dem Ausgang der Ansteuerung 104 verbunden. Der Ausgang 111 der anschlussseitigen steuerbaren Schalteinrichtung ist mit dem Eingang des Ausgangsanschlusses 102 verbunden.

Die Ansteuerung 104 hat zwei Eingänge und zwei Ausgänge. Ein Eingang 110 ist mit dem Ausgang 110 des Solarmoduls 101 verbunden. Der zweite Eingang 111 ist mit dem Ausgangsanschluss 102 verbunden. Ein Ausgang 112 der Ansteuerung 104 ist mit dem Eingang der modulseitigen steuerbaren Schalteinrichtung 200 verbunden, der zweite Ausgang 112 der Ansteuerung 104 ist mit der anschlussseitigen steuerbaren Schalteinrichtung 201 verbunden.

Der DC/DC-Wandler 105 hat einen Eingang und einen Ausgang. Der Eingang 202 ist mit dem Ausgang der modulseitigen steuerbaren Schalteinrichtung 200 verbunden und der Ausgang 203 des DC/DC-Wandlers 105 ist mit dem Eingang 203 der anschlussseitigen steuerbaren Schalteinrichtung 201 verbunden.

Sowohl die steuerbare Schalteinrichtung auf der Modulseite 200 als auch der DC/DC-Wandler 105 funktionieren in gleicher Weise, wie bereits in Fig. 1 beschrieben. Statt der Verzweigung 120 aus Fig. 1 ist in Fig. 4 an dieser Stelle eine anschlussseitige steuerbare Schalteinrichtung 201 angeschaltet, welche eine alternative Ausbildung darstellt. Modulseitige steuerbare Schalteinrichtung 200 als auch anschlussseitige steuerbare Schalteinrichtung 201 lassen sich sowohl in diskreter als auch analoger Schaltungstechnik realisieren, wie bereits in Fig. 1 ausführlich erklärt wurde. Die Ansteuerung 104 arbeitet in gleicher Weise wie in Fig. 1 erläutert, wobei hier der Unterschied darin besteht, dass zwei Ansteuersignale 112 erzeugt werden anstatt eines Ansteuersignals wie in Fig. 1. Beide Ansteuersignale 112 sind jedoch identisch zum Ansteuersignal 112 aus Fig. 1, weshalb auch in der Bezeichnung kein Unterschied gemacht wird. Mit dem Ansteuersignal 112 können sowohl modulseitige steuerbare Schalteinrichtung 200 als auch anschlussseitige steuerbare Schalteinrichtung 201 angesteuert werden. Steuert die Ansteuerung 104 mittels Ansteuersignal 112 die modulseitige steuerbare Schalteinrichtung 200 in der Weise an, dieselbe in die erste Schalterstellung zu schalten, so wird gleichzeitig die anschlussseitige steuerbare Schalteinrichtung 201 in die erste Schalterstellung geschaltet. Entsprechendes gilt für die zweite Schalterstellung.

Bei der ersten Schalterstellung ist der Leistungsausgang des Solarmoduls 110 über den DC/DC-Wandler 105 auf den Ausgangsanschluss 102 geschaltet. Bei der zweiten Schalterstellung ist der Leistungsausgang des Solarmoduls 110 unter Umgehung des DC/DC-Wandlers 105 auf den Ausgangsanschluss 102 geschaltet. Die modulseitige steuerbare Schalteinrichtung 200 schaltet dabei einen Eingang 110 auf einen Ausgang 202 oder einen zweiten Ausgang 204 in Abhängigkeit des Ansteuersignals 112. Die anschlussseitige steuerbare Schalteinrichtung 201 dagegen schaltet einen Eingang 203 oder einen zweiten Eingang 204 auf einen Ausgang 111 in Abhängigkeit von dem Ansteuersignal 112 der Ansteuerung 104.

Fig. 5 zeigt ein mögliches Blockschaltbild für die Ansteuerung 104 für die steuerbare Umschaltvorrichtung 100. Die Ansteuerung 104 umfasst einen Komparator 300, eine Fehlerhandhabungseinrichtung 301 und eine Alarmhandhabungseinrichtung 302. Die Ansteuerung 104 weist vier Eingänge und einen Ausgang auf. Ein Eingang 330 speist eine Leistungskenngröße ein und ist in einer bevorzugten Ausführung mit dem Ausgang 110 des Solarmoduls 101 verbunden, kann aber auch eine auf andere Weise gemessene Leistungskenngröße umfassen, beispielsweise eine abgeleitete Leistungskenngröße aus dem Ausgang 110 des Solarmoduls 101 und dem Eingang 111 des Ausgangsanschlusses 102. In einer weiteren Ausbildung kann der Eingang 330 auch ausgebildet sein aus einem ersten Eingang, der beispielsweise den Ausgang 110 einspeist und einem zweiten Eingang, der beispielsweise den Eingang 111 einspeist.

Der zweite Eingang 320 dient dazu, eine externe oder interne Referenzleistungskenngröße für das Solarmodul an die Ansteuerung 104 anzuschalten. Der dritte Eingang 310 speist ein Fehlersignal F in die Fehlerhandhabungseinrichtung ein. Der vierte Eingang 311 speist ein Alarmsignal in die Alarmhandhabungseinrichtung ein. Der Ausgang 112 der Ansteuerung 104 ist mit der steuerbaren Schalteinrichtung 103 nach Fig. 1 oder gleichzeitig mit der modulseitigen steuerbaren Schalteinrichtung 200 nach Fig. 4 und der anschlussseitigen steuerbaren Schalteinrichtung 201 nach Fig. 4 verbunden. Der gestrichelte Pfeil in Fig. 4 deutet dies an, die Ansteuerung 104 liefert einen Ausgang oder zusätzlich einen zweiten Ausgang (gestrichelt) je nach Ausbildung der steuerbaren Schalteinrichtung 103 bzw. 200 und 201.

Der Komparator 300 hat zwei Eingänge und einen Ausgang. Ein Eingang 330 speist eine Leistungskenngröße ein und ist in einer bevorzugten Ausführung mit dem Ausgang des Solarmoduls 101 verbunden, kann aber entsprechend obiger Ausführung auch mit einem oder mehreren anderen Ein- bzw. Ausgängen verbunden sein. Der zweite Eingang 320 ist mit einem Eingang zum Anschalten einer Referenzleistungskenngröße verbunden. Der Ausgang 312 des Komparators 300 ist mit dem Eingang der Fehlerhandhabungseinrichtung 301 verbunden.

Die Fehlerhandhabungseinrichtung 301 weist zwei Eingänge und einen Ausgang auf. Ein Eingang 312 ist mit dem Ausgang des Komparators 300 verbunden, der zweite Eingang 310 ist mit einem Eingang zum Anschalten eines Fehlersignals verbunden. Der Ausgang 313 der Fehlerhandhabungseinrichtung 301 ist mit dem Eingang der Alarmhandhabungseinrichtung 302 verbunden.

Die Alarmhandhabungseinrichtung 302 weist zwei Eingänge und einen Ausgang auf. Ein Eingang 313 ist mit dem Ausgang der Fehlerhandhabungseinrichtung 301 verbunden, der zweite Eingang 311 ist mit einem Eingang zum Anschalten eines Alarmsignals verbunden. Der Ausgang 112 der Alarmhandhabungseinrichtung 302 ist gleich dem Ausgang 112 der Ansteuerung 104 und ist mit dem Ansteuereingang 112 der steuerbaren Schalteinrichtung 103 nach Fig. 1 bzw. der modulseitigen steuerbaren Schalteinrichtung 200 und der anschlussseitigen steuerbaren Schalteinrichtung 201 nach Fig. 4 verbunden. Für den zweiten Fall deutet die gestrichelte Linie in Fig. 5 an, dass das Ansteuersignal 112 sowohl zu 200 als auch zu 201 gelangen soll.

Der Komparator 300 der Ansteuerung 104 ist ausgebildet, um einen Vergleich zwischen der Leistungskenngröße am Eingang 330 und der Referenzleistungskenngröße 320 auszuführen. In einer besonderen Ausführung des Komparators 300 wird geprüft, ob die Leistungskenngröße am Eingang 330 größer oder gleich der Referenzleistungskenngröße 320 ist. Ist diese Bedingung erfüllt, so schaltet der Komparator 300 sein Ausgangssignal 312 in den Zustand "zweite Schalterstellung", was die steuerbare Umschaltvorrichtung dahingehend ansteuern soll, den Leistungsausgang 110 des Solarmoduls 101 unter Umgehung des DC/DC-Wandlers 105 auf den Ausgangsanschluss 102 zu schalten. Ist die vorgenannte Bedingung nicht erfüllt, d. h. Leistungskenngröße am Eingang 330 ist kleiner als die Referenzleistungskenngröße 320, so schaltet der Komparator 300 sein Ausgangssignal 312 in den Zustand "erste Schalterstellung", was bedeutet, dass die steuerbare Schalteinrichtung 103 angesteuert wird, den Leistungsausgang 110 des Solarmoduls 101 über den DC/DC-Wandler 105 auf den Ausgangsanschluss 102 zu schalten.

In einer weiteren Ausbildung ist der Komparator 300 ausgebildet, die steuerbare Schalteinrichtung 103 in die zweite Schalterstellung zu schalten, wenn die am Eingang 330 vorliegende Leistungskenngröße zu der Referenzleistungskenngröße 320 eine bestimmte Beziehung aufweist und die steuerbare Schalteinrichtung 103 in die zweite Schalterstellung zu schalten, wenn dieselbe am Eingang 330 vorliegende Leistungskenngröße zu der Referenzleistungskenngröße 320 diese Beziehung nicht aufweist.

Die Referenzleistungskenngröße 320 kann über den Eingang für die Referenzleistungskenngröße extern eingespeist werden, gespeichert, fest integriert oder aus der Leistungskenngröße 110 des Leistungsausgangs des Solarmoduls 101 abgeleitet werden. Die Referenzleistungskenngröße 320 ist beispielsweise eine feste Leistungskenngröße, die als Referenz für die Leistungskenngröße am Eingang 330 dient. Das heißt, mit der Referenzleistungskenngröße 320 ist eine Unterscheidung möglich, ob das Solarmodul 101 mit voller Leistung arbeitet oder sich im abgeschatteten Zustand befindet und mit reduzierter Leistung arbeitet. Die Referenzleistungskenngröße kann beispielsweise von außen eingespeist, d. h. mittels eines Generators erzeugt werden und dann in einem Speicher der steuerbaren Umschaltvorrichtung 100 gespeichert werden. Die Referenzleistungskenngröße 320 kann auch einen festen Wert haben, der fest in der steuerbaren Umschaltvorrichtung 100 integriert ist. In einer bevorzugten Ausführung wird die Referenzleistungskenngröße 320 aus der Leistungskenngröße 110 am Leistungsausgang des Solarmoduls 101 und der Leistungskenngröße 111 am Ausgangsanschluss 102 abgeleitet.

Eine bevorzugte Ausführung der Ableitung der Referenzleistungskenngröße 320 besteht darin, aus der Leistungskenngröße 110 am Leistungsausgang des Solarmoduls 101 oder aus der Leistungskenngröße 111 am Ausgangsanschluss 102 einen zeitlichen Maximalwert zu bilden und das Maximum als Referenzleistungskenngröße 320 zu verwenden. In typischen Anwendungen variiert die Leistungskenngröße 110 am Leistungsausgang des Solarmoduls 101 mit der Zeit. In Zeiten starker Sonneneinstrahlung liefert das Solarmodul 101 die maximale Leistung, in Zeiten schwächerer Sonneneinstrahlung oder Abschattung liefert das Solarmodul 101 nur eine reduzierte Leistung, welche sich in der Leistungskenngröße 110 am Leistungsausgang des Solarmoduls 101 manifestiert. Bildet man das Maximum dieser Leistungskenngröße 110 am Leistungsausgang des Solarmoduls 101, so erhält man den Wert maximaler Leistungserzeugung des Solarmoduls. Mit Hilfe dieses Wertes kann entschieden werden, ob der Ausgang 110 des Solarmoduls 101 direkt auf den Ausgangsanschluss 102 geschaltet werden kann oder ob ein DC/DC-Wandler 105 notwendig ist.

Die Fehlerhandhabungseinrichtung 301 weist als Eingang 312 den Ausgang des Komparators 300 auf. Mit einem zweiten Eingang 310 ist die Fehlerhandhabungseinrichtung 301 mit dem Fehlerausgang verbunden. Über den Fehlerausgang werden Fehler der Ansteuerung 104 mitgeteilt, d. h. tritt ein Defekt in der steuerbaren Schalteinrichtung 103 bzw. modulseitiger steuerbaren Schalteinrichtung 200 oder anschlussseitiger steuerbaren Schalteinrichtung 201 auf, so wird über den Fehleranschluss der Fehlerhandhabungseinrichtung 301 signalisiert, dass ein Fehler vorliegt. Ebenso werden Fehler des DC/DC-Wandlers 105 dem Fehlereingang 310 der Ansteuerung 104 mitgeteilt. Die Fehlerhandhabungseinrichtung 301 entscheidet sich in einer bevorzugten Ausführung bei Auftreten eines Fehlers am Fehlerausgang 310, die steuerbare Schalteinrichtung 103 in die zweite Schalterstellung zu schalten. Dies bedeutet, dass das Solarmodul 101 unter Umgehung des DC/DC-Wandlers 105 direkt auf den Ausgangsanschluss 102 durchgeschaltet wird. Tritt kein Fehler auf, so wird das Ausgangssignal des Komparators 312 direkt auf den Ausgang der Fehlerhandhabungseinrichtung 313 durchgeschaltet. Bei Auftreten eines Fehlers steuert das Ausgangssignal der Fehlerhandhabungseinrichtung 313 die steuerbare Schalteinrichtung 103 in der Weise an, dieselbe in die zweite Schalterstellung zu schalten.

Die Alarmhandhabungseinrichtung 302 weist zwei Eingänge und einen Ausgang auf. Ein Eingang 313 ist mit dem Ausgang der Fehlerhandhabungseinrichtung 301 verschaltet, der zweite Eingang 311 ist an den Alarmausgang geschaltet. Der Ausgang der Alarmhandhabungseinrichtung 112 entspricht dem Ausgang der Ansteuerung 104 und ist Eingang der steuerbaren Schalteinrichtung 103. Die Alarmhandhabungseinrichtung 302 ist ausgebildet, die steuerbare Schalteinrichtung 103 in eine dritte Schalterstellung zu schalten, wenn ein Alarm vorliegt. Diese dritte Schalterstellung ist ausgebildet, den Ausgang des Solarmoduls 101 von dem Ausgangsanschluss 102 zu trennen, d. h. bei Vorliegen eines Alarms ist das Solarmodul 101 von seinem Ausgangsanschluss 102 entkoppelt. Dies ist sinnvoll im Falle eines Brandes. Dazu ist der Alarmausgang 311 mit einem Branddetektor gekoppelt und meldet der Alarmhandhabungseinrichtung 302 einen Brandalarm. Weitere Ausführungen für Alarme wären beispielsweise ein Defekt des DC/DC-Wandlers 105, welcher dazu führen kann, dass der Ausgangsanschluss 102 mit einer zu hohen Leistung beaufschlagt wird. Der Fall eines Fehlers des DC/DC-Wandlers 105 ist zwar schon mit Hilfe des Fehlerausgangs 310 abgedeckt, indem der Solarmodulanschluss 101 direkt auf den Ausgangsanschluss 102 durchgeschaltet wird, aber eine weitere Möglichkeit der Vorgehensweise kann sein, den Solarmodulanschluss 101 vom Ausgangsanschluss 102 zu trennen und gleichzeitig dem Bediener einen Alarm mitzuteilen. Dies kann mittels der Alarmhandhabungseinrichtung 302 bewirkt werden.

Während in der bevorzugten Ausbildung der Komparator 300 vor der Fehlerhandhabungseinrichtung 301 und diese vor der Alarmhandhabungseinrichtung 302 geschaltet sind, kann diese Reihenfolge auch vertauscht werden. In einer anderen Ausbildung ist es auch möglich, den Komparatorausgang 312 an den Eingang der Alarmhandhabungseinrichtung 302 anzuschlieβen und den Ausgang der Alarmhandhabungseinrichtung 302 an den Eingang der Fehlerhandhabungseinrichtung 301 anzuschließen und dessen Ausgang an den Eingang der steuerbaren Schalteinrichtung 103 anzuschließen. Auch können Fehlerhandhabungseinrichtung 301 und Alarmhandhabungseinrichtung 302 vor dem Komparator 300 ausgeführt werden, es ist ein beliebiges Vertauschen der Reihenfolge der drei Blöcke 300, 301 und 302 möglich.

Befindet sich die steuerbare Umschaltvorrichtung 100 in einem nichtangesteuerten Zustand, so schaltet der Ausgang 112 der Ansteuerung 104 die steuerbare Schalteinrichtung 103 in der Weise an, dieselbe in die zweite Schalterstellung zu steuern. Liegt ein Ausgangssignal 112 der Ansteuerung 104 nicht vor, so ist die steuerbare Schalteinrichtung 103 derart ausgebildet, dass sie sich im Zustand der zweiten Schalterstellung befindet, d. h. der Solarmodulausgang 101 wird an den Ausgangsanschluss 102 unter Umgehung des DC/DC-Wandlers 105 durchgeschaltet.

Obwohl der Komparator 300 in Fig. 5 nur mit einem Eingang 330 für die Leistungskenngröße dargestellt ist, kann der Komparator 300, wie bereits oben dargelegt, auch einen weiteren Eingang für eine zweite Leistungskenngröße aufweisen. Beispielsweise kann er einen Eingang 110 und einen Eingang 111 aufweisen und diese in Beziehung zu der Referenzleistungskenngröße (PR) am Eingang 320 setzen.

Der Komparator 300 kann in einer weiteren Ausbildung auch einen zusätzlichen Eingang für eine zweite Referenzleistungskenngröße aufweisen. Weiterhin kann der Komparator 300 mehrere Eingänge für Leistungskenngrößen aufweisen, und mehrere Eingänge für Referenzleistungskenngrößen, wobei er dann die Leistungskenngrößen zu den Referenzleistungskenngrößen in Beziehung setzen kann.

Fig. 6 zeigt ein Flussdiagramm zur Veranschaulichung der Funktionsweise der Ansteuerung von Fig. 5. Die Eingangsgrößen des Flussdiagramms sind die Leistungskenngröße (P) am Eingang 330, die Referenzleistungskenngröße (PR) am Eingang 111, der Fehler (F) am Eingang 310 und der Alarm (A) am Eingang 311. Der Ausgang des Flussdiagramms ist der Ausgang 112 der Ansteuerung 104 und damit gleichzeitig der Eingang der Steuerbaren Schalteinrichtung 103.

In einem ersten Vergleichsschritt eines bedingten Verzweigers 400 wird überprüft, ob die Leistungskenngröße (P) am Eingang 330 größer oder gleich der Referenzleistungskenngröße (PR) am Eingang 320 ist. Ist dies der Fall, so wird die steuerbare Schalteinrichtung 103 in einer Anweisung 401 dahingehend angesteuert, dieselbe in die zweite Schalterstellung zu stellen, d. h. das Solarmodul 101 direkt unter Umgehung des DC/DC-Wandlers 105 auf den Ausgangsanschluss 102 durchzuschalten. Ist die Bedingung des bedingten Verzweigers 400 nicht erfüllt, so wird die steuerbare Schalteinrichtung 103 dahingehend angesteuert, dieselbe in die erste Schalterstellung zu schalten, d. h. Solarmodulausgang 101 wird über den DC/DC-Wandler 105 an den Ausgangsanschluss 102 geschaltet. Nach der Schalteransteuerung werden die zwei Zweige des bedingten Verzweigers 400 in einem Punkt 407 wieder zusammengeführt und je nachdem, ob der Ja-Fall oder der Nein-Fall der Bedingung des bedingten Verzweigers 400 durchlaufen wurde, ergibt sich ein anderes Ansteuersignal 312, das nun das Eingangssignal für die Abfrage des bedingten Verzweigers 403 ist.

In dieser Abfrage wird überprüft, ob ein Fehler (F) am Eingang 310 anliegt. Für den Ja-Fall wird das Steuersignal in einer Anweisung 404 dahingehend ausgesteuert, die steuerbare Schalteinrichtung 103 in die zweite Schalterstellung zu schalten. Für den Nein-Fall, d. h. es ist kein Fehler vorhanden, wird das anliegende Ansteuersignal 312 nicht verändert. Beide Zweige der Abfrage des bedingten Verzweigers 403 werden in einem Punkt 408 zusammengeführt, so dass ein Ansteuersignal 313 entsteht, welches das Eingangssignal für die Abfrage des bedingten Verzweigers 405 ist.

In der Abfrage des bedingten Verzweigers 405 wird geprüft, ob am Alarmeingang 311 ein Alarm anliegt. Ist dies der Fall, so wird die steuerbare Schalteinrichtung 103 dahingehend angesteuert, dieselbe in einer Anweisung 406 in die dritte Schalterstellung zu schalten, was bedeutet, das Solarmodul 101 von dem Ausgangsanschluss 102 zu trennen. Zeigt die Abfrage des bedingten Verzweigers 405, dass kein Alarm aufgetreten ist, so wird das Eingangsansteuersignal 313 der Alarmhandhabungseinrichtung 302 unverändert auf den Ausgang geschaltet. Beide Verzweigungen des bedingten Verzweigers 405 werden in einem Punkt 409 zusammengeführt und bestimmen den Ausgang 112 der Ansteuerung 104 zur Ansteuerung der steuerbaren Schalteinrichtung 103.

Wie bereits in Fig. 5 erwähnt ist es möglich, die Reihenfolge der Abfragen zu vertauschen. In einer weiteren Ausführung kann beispielsweise die Alarmabfrage 405 an erster Stelle durchlaufen werden und bei Vorliegen eines Alarms die weiteren Abfragen übersprungen werden. Danach kann die Fehlerabfrage 403 ausgeführt werden und bei einem Vorliegen eines Fehlers die weiteren Abfragen übersprungen werden. Als letztes könnte dann der Leistungsvergleich 400 zwischen Kenngröße am Leistungsausgang des Solarmoduls und Referenzleistungskenngröße ausgeführt werden.

Fig. 7A und 7B zeigen Blockschaltbilder für herkömmliche Anschlusskonfigurationen für Solarmodule 101. Das Solarmodul 101 wird herkömmlicherweise direkt mit seinem Ausgangsanschluss 102 verbunden, wie in Fig. 7A dargestellt. Ein Nachteil der direkten Anschaltung gemäß Fig. 7A tritt allerdings bei Teilabschattung des Solarmoduls 101 auf.

Wird ein Teilstring des Solarmoduls 101 abgeschattet, so leitet, wie bereits oben erwähnt, dessen Freilaufdiode den Differenzstrom zwischen dem Strom des abgeschatteten Modulstrings 101 und des Solargeneratorstrangs und der abgeschattete Modulstring 101 produziert keine ausreichende Leistung mehr. Um dies zu verhindern, kann der DC/DC-Wandler 105, wie in Fig.7B dargestellt, eingesetzt werden. Der DC/DC-Wandler 105 passt den Strom und die Spannung derart an, dass der abgeschattete Modulstring 101 weiterhin Leistung abgibt. Allerdings arbeitet der DC/DC-Wandler 105 auch im nicht abgeschatteten Zustand und beeinträchtigt dann den Gesamtwirkungsgrad des Solargenerators durch die an seinen Bauelementen abfallende Leistung.

Eine weitere Ausführung lässt sich auch folgendermaßen beschreiben: Die Erfindung besteht aus einer Ansteuerung 104, welche auch als Detektionseinrichtung ausgebildet sein kann, die den Fall der Abschattung eines Modulstrings 101 erkennt, und aus einer Umschalteinrichtung 103, die im nichtabgeschatteten Fall eine direkte Verbindung zwischen dem Modulstring 101 und den Ausgangsklemmen 102 des Solarmoduls herstellt und im abgeschattete Fall den abgeschatteten Teilstring 101 über einen DC/DC-Wandler 105 mit den Ausgangsklemmen 102 des Solarmoduls verbindet.

Vorteilhaft ist diese Umschalteinrichtung 100 so ausgestaltet, dass sie standardmäßig die direkte Verbindung herstellt und die Verbindung über den DC/DC-Wandler 105 aktiv eingeschaltet werden muss.

Weiterhin ist die Umschalteinrichtung 100 vorteilhaft so ausgestaltet, dass im Falle eines Fehlers oder eines Defektes des Abschaltungsdetektors 104 oder des DC/DC-Wandlers 105 die direkte Verbindung zu den Ausgangsklemmen hergestellt wird.

Eine weitere vorteilhafte Ausführung der Erfindung gestattet es, dass durch die Umschalteinrichtung 100 das Solarmodul 101 von den Anschlüssen 102 getrennt werden kann. Dies ist insbesondere im Brandfall sinnvoll. Dazu erhält die Detektionseinrichtung D einen weiteren Detektor zur Detektion eines Brandes.

Abhängig von den Gegebenheiten kann das erfindungsgemäße Verfahren in Hardware oder in Software implementiert werden. Die Implementierung kann auf einem digitalen Speichermedium, insbesondere einer Diskette oder einer CD, mit elektronisch auslesbaren Steuersignalen erfolgen, die so mit einem programmierbaren Computersystem zusammenwirken können, dass das entsprechende Verfahren ausgeführt wird. Allgemein besteht die Erfindung somit auch in einem Computerprogrammprodukt mit auf einem maschinenlesbaren Träger gespeicherten Programmcode zur Durchführung des erfindungsgemäßen Verfahrens, wenn das Computerprogrammprodukt auf einem Rechner abläuft. In anderen Worten ausgedrückt kann die Erfindung somit als ein Computerprogramm mit einem Programmcode zur Durchführung des Verfahrens realisiert werden, wenn das Computerprogramm auf einem Computer abläuft.

## Patentansprüche

1. Steuerbare Umschältvorrichtung (100) für ein Solarmodul (101) mit folgenden Merkmalen:
einem Ausgangsanschluss (102);
einem DC/DC-Wandler (105);
einer steuerbaren Schalteinrichtung (103, 103') mit einer ersten Schalterstellung und einer zweiten Schalterstellung; und
einer Ansteuerung (104) zum Ansteuern der steuerbaren Schalteinrichtung (103), um unter Verwendung einer am Leistungsausgang des Solarmoduls (101) vorliegenden Leistungskenngröße (110) oder einer am Ausgangsanschluss (102) vorliegenden Leistungskenngröße (111) die steuerbare Schalteinrichtung (103) in die erste Schalterstellung oder in die zweite Schalterstellung zu schalten,
wobei ein Leistungsausgang (110) des Solarmoduls (101) in der ersten Schalterstellung nur über einen ersten Pfad, der den DC/DC-Wandler (105) umfasst, mit dem Ausgangsanschluss (102) verbunden ist, und
wobei der Leistungsausgang (110) des Solarmoduls (101) in der zweiten Schalterstellung nur über einen zweiten Pfad, der den DC/DC-Wandler (105) umgeht; mit dem Ausgangsanschluss (102) verbunden ist.

2. Steuerbare Umschaltvorrichtung (100) nach Anspruch 1, wobei die Ansteuerung (104) ferner ausgebildet ist, um abhängig von der am Leistungsausgang des Solarmoduls (101) vorliegenden Leistungskenngröße (110) einen Arbeitspunkt des Solarmoduls einzustellen.

3. Steuerbare Umschaltvorrichtung (100) nach den Ansprüchen 1 oder 2, wobei die Ansteuerung (104) die folgenden Merkmale aufweist:
einen Eingang für eine Referenzleistungskenngröße (320),
einen Komparator (300) zum Vergleichen der am Leistungsausgang des Solarmoduls (101) vorliegenden Leistungskenngröße (110) mit der Referenzleistungskenngröße (320),
wobei der Komparator (300) ausgebildet ist, die steuerbare Schalteinrichtung (103) in die zweite Schalterstellung zu schalten, wenn die am Leistungsausgang des Solarmoduls (101) vorliegende Leistungskenngröße (110) zu der Referenzleistungskenngröße (320) eine bestimmte Beziehung aufweist, und die steuerbare Schalteinrichtung (103) in die zweite Schalterstellung zu schalten, wenn die am Leistungsausgang des Solarmoduls (101) vorliegende Leistungskenngröße (110) zu der Referenzleistungskenngröße (320) diese Beziehung nicht aufweist.

4. Steuerbare Umschaltvorrichtung (100) nach einem der Ansprüche 1 bis 3, wobei die steuerbare Schalteinrichtung (103) derart ausgebildet ist, dass sich dieselbe in einem nicht angesteuerten Fall in der zweiten Schalterstellung befindet.

5. Steuerbare Umschaltvorrichtung (100) nach einem der vorhergehenden Ansprüche, bei der die Ansteuerung (104) ferner folgendes Merkmal aufweist:
eine Fehlerhandhabungseinrichtung (301) zum Erkennen eines Defektes der steuerbaren Schalteinrichtung (103) oder des DC/DC-Wandlers (105), welche ausgebildet ist, die steuerbare Schalteinrichtung (103) in die zweite Schalterstellung zu schalten, falls ein Fehler der steuerbaren Schalteinrichtung (103) oder des DC/DC-Wandlers (105) vorliegt.

6. Steuerbare Umschaltvorrichtung (100) nach einem der vorhergehenden Ansprüche, bei der die steuerbare Schalteinrichtung (103) ferner folgendes Merkmal aufweist:
eine dritte Schalterstellung, bei der der Leistungsausgang (110) des Solarmoduls (101) von dem Ausgangsanschluss (102) getrennt ist.

7. Steuerbare Umschaltvorrichtung (100) nach Anspruch 6, bei der die Ansteuerung (104) ferner folgendes Merkmal aufweist:
eine Alarmhandhabungseinrichtung (302) zum Erkennen eines Alarms der steuerbaren Umschaltvorrichtung (100), des Solarmoduls (101) oder des Ausgangsanschlusses (102), welche ausgebildet ist, die steuerbare Schalteinrichtung (103) in die dritte Schalterstellung zu schalten, falls ein Alarm der steuerbaren Umschaltvorrichtung (100), des Solarmoduls (101) oder des Ausgangsanschlusses (102) vorliegt.

8. Steuerbare Umschaltvorrichtung (100) nach Anspruch 3, wobei die Referenzleistungskenngröße (320) über den Eingang für die Referenzleistungskenngröße extern eingespeist, gespeichert, fest integriert oder aus der Leistungskenngröße (110) des Leistungsausgangs des Solarmoduls (101) abgeleitet ist.

9. Steuerbare Umschaltvorrichtung (100) nach Anspruch 1, bei der die steuerbare Schalteinrichtung (103') und der DC/DC-Wandler (105) parallel zwischen einen Leistungsausgang (110) des Solarmoduls und den Ausgangsanschluss geschaltet sind.

10. Steuerbare Umschaltvorrichtung (100) nach Anspruch 9, bei der die steuerbare Schalteinrichtung (103') einen mechanischen Schalter oder einen Halbleiterschalter umfasst.

11. Verfahren zum Steuern einer steuerbaren Umschaltvorrichtung (100) für ein Solarmodul (101), wobei die steuerbare Umschaltvorrichtung (100) einen Ausgangsanschluss (102), einen DC/DC-Wandler (105), und eine steuerbaren Schalteinrichtung (103) mit einer ersten Schalterstellung und einer zweiten Schalterstellung umfasst und wobei das Verfahren folgenden Schritt aufweist:
Ansteuern der steuerbaren Schalteinrichtung (103), um unter Verwendung der am Leistungsausgang des Solarmoduls (101) vorliegenden Leistungskenngröße (110) oder der am Ausgangsanschluss (102) vorliegenden Leistungskenngröße (111) die steuerbare Schalteinrichtung (103) in die erste Schalterstellung oder in die zweite Schalterstellung zu schalten,
wobei ein Leistungsausgang (110) des Solarmoduls (101) in der ersten Schalterstellung nur über einen ersten Pfad, der den DC/DC-Wandler (105) umfasst, mit dem Ausgangsanschluss (102) verbunden ist, und
wobei der Leistungsausgang (110) des Solarmoduls (101) in der zweiten Schalterstellung nur über einen zweiten Pfad, der den DC/DC-Wandler (105) umgeht, mit dem Ausgangsanschluss (102) verbunden ist.

12. Computerprogramm mit einem Programmcode zum Ausführen des Verfahrens gemäß Patentanspruch 11, wenn das Computerprogramm auf einem Rechner läuft.

## Claims

1. Controllable change-over apparatus (100) for a solar module (101), comprising:
an output terminal (102);
a DC/DC converter (105);
a controllable switching device (103, 103') with a first switch position and a second switch position; and
a control (104) for controlling the controllable switching device (103) for switching the controllable switching device (103) to the first switch position or the second switch position by using a performance characteristic (110) present at the power output of the solar module (101) or a performance characteristic (111) present at the output terminal (102),
wherein, in the first switch position, a power output (110) of the solar module (101) is only connected to the output terminal (102) via a first path comprising the DC/DC converter (105), and
wherein, in the second switch position, the power output (110) of the solar module (101) is only connected to the output terminal (102) via a second path bypassing the DC/DC converter (105).

2. Controllable change-over apparatus (100) according to claim 1, wherein the control (104) is further implemented to set an operating point of the solar module in dependence on the performance characteristic (110) present at the power output of the solar module (101).

3. Controllable change-over apparatus (100) according to claims 1 or 2, wherein the control (104) comprises:
an input for a reference performance characteristic (320),
a comparator (300) for comparing the performance characteristic (110) present at the power output of the solar module (101) with the reference performance characteristic (320),
wherein the comparator (300) is implemented to switch the controllable switching device (103) to the second switch position when the performance characteristic (110) present at the power output of the solar module (101) has a certain relation to the reference performance characteristic (320), and to switch the controllable switching device (103) to the second switch position when the performance characteristic (110) present at the power output of the solar module (101) does not have this relation to the reference performance characteristic (320).

4. Controllable change-over apparatus (100) according to one of claims 1 to 3, wherein the controllable switching device (103) is implemented such that the same is in the second switch position in a non-controlled case.

5. Controllable change-over apparatus (100) according to one of the previous claims, wherein the control (104) further comprises:
an error-handling device (301) for detecting a defect of the controllable switching device (103) or the DC/DC converter (105), which is implemented to switch the controllable switching device (103) to the second switch position if an error of the controllable switching device (103) or the DC/DC converter (105) is present.

6. Controllable change-over apparatus (100) according to one of the previous claims, wherein the controllable switching device (103) further comprises:
a third switch position, wherein the power output (110) of the solar module (101) is separated from the output terminal (102).

7. Controllable change-over apparatus (100) according to claim 6, wherein the control (104) further comprises:
an alarm-handling device (302) for detecting an alarm of the controllable change-over apparatus (100), the solar module (101) or the output terminal (102), which is implemented to switch the controllable switching device (103) to the third switch position if an alarm of the controllable change-over apparatus (100), the solar module (101) or the output terminal (102) is present.

8. Controllable change-over apparatus (100) according to claim 3, wherein the reference performance characteristic (320) is externally fed via the input for the reference performance characteristic, stored, firmly integrated or derived from the performance characteristic (110) of the power output of the solar module (101).

9. Controllable change-over apparatus (100) according to claim 1, wherein the controllable switching device (103') and the DC/DC converter (105) are connected in parallel between a power output (110) of the solar module and the output terminal.

10. Controllable change-over apparatus (100) according to claim 9, wherein the controllable switching device (103') comprises a mechanical switch or a semiconductor switch.

11. Method for controlling a controllable change-over apparatus (100) for a solar module (101), the controllable change-over apparatus (100) comprising an output terminal (102), a DC/DC converter (105), and a controllable switching device (103) with a first switch position and a second switch position, the method comprising:
controlling the controllable switching device (103) for switching the controllable switching device (103) to the first switch position or to the second switch position by using the performance characteristic (110) present at the power output of the solar module (101) or the performance characteristic (111) present at the output terminal (102),
wherein, in the first switch position, a power output (110) of the solar module (101) is only connected to the output terminal (102) via a first path comprising the DC/DC converter (105), and
wherein, in the second switch position, the power output (110) of the solar module (101) is only connected to the output terminal (102) via a second path bypassing the DC/DC converter (105).

12. Computer program having a program code for performing the method according to claim 11 when the computer program runs on a computer.

## Revendications

1. Dispositif de commutation régulable (100) pour un module solaire (101), aux caractéristiques suivantes:
une connexion de sortie (102);
un convertisseur CC/CC (105);
un moyen de commutation régulable (103, 103') avec une première position de commutateur et une deuxième position de commutateur; et
un moyen d'activation (104) destiné à activer le moyen de commutation régulable (103), pour commuter, à l'aide d'une grandeur de puissance caractéristique (110) présente à la sortie de puissance du module solaire (101) ou d'une grandeur de puissance caractéristique (111) présente à la connexion de sortie (102), le moyen de commutation régulable (103) dans la première position de commutateur ou dans la deuxième position de commutateur,
dans lequel une sortie de puissance (110) du module solaire (101) n'est, dans la première position de commutateur, reliée à la connexion de sortie (102) que par un premier trajet comportant le convertisseur CC/CC (105), et
dans lequel la sortie de puissance (110) du module solaire (101) n'est, dans la deuxième position de commutateur, reliée à la connexion de sortie (102) que par un deuxième trajet contournant le convertisseur CC/CC (105).

2. Dispositif de commutation régulable (100) selon la revendication 1, dans lequel le moyen d'activation (104) est par ailleurs réalisé de manière à régler un point de fonctionnement du module solaire en fonction de la grandeur de puissance (110) présente à la sortie de puissance du module solaire (101).

3. Dispositif de commutation régulable (100) selon les revendications 1 ou 2, dans lequel le moyen d'activation (104) présente les caractéristiques suivantes:
une entrée pour une grandeur caractéristique de référence (320),
un comparateur (300) destiné à comparer la grandeur de puissance caractéristique (110) présente à la sortie de puissance du module solaire (101) avec la grandeur caractéristique de référence (320),
le comparateur (300) étant réalisé pour commuter le moyen de commutation régulable (103) dans la deuxième position de commutateur lorsque la grandeur de puissance caractéristique (110) présente à la sortie de puissance du module solaire (101) présente un rapport déterminé avec la grandeur caractéristique de référence (320), et pour commuter le moyen de commutation régulable (103) dans la deuxième position de commutateur lorsque la grandeur de puissance caractéristique (110) présente à la sortie de puissance du module solaire (101) ne présente pas ce rapport avec la grandeur caractéristique de référence (320).

4. Dispositif de commutation régulable (100) selon l'une des revendications 1 à 3, dans lequel le moyen de commutation régulable (103) est réalisé de sorte qu'il se trouve, dans un cas non activé, dans la deuxième position de commutateur.

5. Dispositif de commutation régulable (100) selon l'une des revendications précédentes, dans lequel le moyen d'activation (104) présente par ailleurs la caractéristique suivante:
un moyen de manipulation d'erreur (301) destiné à identifier un défaut du moyen de commutation régulable (103) ou du convertisseur CC/ CC (105), qui est réalisé pour commuter le moyen de commutation régulable (103) dans la deuxième position de commutateur lorsqu'une erreur du moyen de commutation régulable (103) ou du convertisseur CC/CC (105) est présente.

6. Dispositif de commutation régulable (100) selon l'une des revendications précédentes, dans lequel le moyen de commutation régulable (103) présente par ailleurs la caractéristique suivante:
une troisième position de commutateur, dans laquelle la sortie de puissance (110) du module solaire (101) est séparée de la connexion de sortie (102).

7. Dispositif de commutation régulable (100) selon la revendication 6, dans lequel le moyen d'activation (104) présente par ailleurs la caractéristique suivante:
un moyen de manipulation d'alarme (302) destiné à identifier une alarme du dispositif de commutation régulable (100), du module solaire (101) ou de la connexion de sortie (102), lequel est réalisé pour commuter le moyen de commutation régulable (103) dans la troisième position de commutateur lorsqu'une alarme du dispositif de commutation régulable (100), du module solaire (101) ou de la connexion de sortie (102) est présente.

8. Dispositif de commutation régulable (100) selon la revendication 3, dans lequel la grandeur caractéristique de référence (320) est alimentée extérieurement via l'entrée pour la grandeur caractéristique de référence, mémorisée, intégrée de manière fixe ou dérivée de la grandeur de puissance caractéristique (110) de la sortie de puissance du module solaire (101).

9. Dispositif de commutation régulable (100) selon la revendication 1, dans lequel le moyen de commutation régulable (103') et le convertisseur CC/CC (105) sont connectés en parallèle entre une sortie de puissance (110) du module solaire et la connexion de sortie.

10. Dispositif de commutation régulable (100) selon la revendication 9, dans lequel le moyen de commutation régulable (103') comporte un commutateur mécanique ou un commutateur à semi-conducteur.

11. Procédé pour réguler un dispositif de commutation régulable (100) pour un module solaire (101), dans lequel le dispositif de commutation régulable (100) comporte une connexion de sortie (102), un convertisseur CC/CC (105), et un moyen de commutation régulable (103) avec une première position de commutateur et une deuxième position de commutateur, et dans lequel le procédé présente l'étape suivante consistant à:
activer le moyen de commutation régulable (103), pour commuter, à l'aide de la grandeur de puissance caractéristique (110) présente à la sortie de puissance du module solaire (101) ou de la grandeur de puissance caractéristique (111) présente à la connexion de sortie (102), le moyen de commutation régulable (103), dans la première position de commutateur ou dans la deuxième position de commutateur,
une sortie de puissance (110) du module solaire (101) n'étant, dans la première position de commutateur, reliée à la connexion de sortie (102) que par une première trajectoire comportant le convertisseur CC/CC (105), et
la sortie de puissance (110) du module solaire (101) n'étant, dans la deuxième position de commutateur, reliée à la connexion de sortie (102) que par une deuxième trajectoire contournant le convertisseur CC/CC (105).

12. Programme d'ordinateur avec un code de programme pour réaliser le procédé selon la revendication 11 lorsque le programme d'ordinateur est exécuté sur un ordinateur.
